(19) Europäisches Patentamt
European Patent Office
Office européen des brevets

(11) **EP 1 550 222 B1**

(12) **EUROPÄISCHE PATENTSCHRIFT**

(45) Veröffentlichungstag und Bekanntmachung des Hinweises auf die Patenterteilung:
**15.08.2007 Patentblatt 2007/33**

(21) Anmeldenummer: **03770906.0**

(22) Anmeldetag: **07.10.2003**

(51) Int Cl.:
*H03M 3/02* ^(2006.01)

(86) Internationale Anmeldenummer:
**PCT/DE2003/003321**

(87) Internationale Veröffentlichungsnummer:
**WO 2004/034588 (22.04.2004 Gazette 2004/17)**

(54) **GESTEUERTE STROMQUELLE, INSBESONDERE FÜR DIGITAL-ANALOG-UMSETZER IN ZEITKONTINUIERLICHEN SIGMA-DELTA-MODULATOREN**

CONTROLLED POWER SOURCE, IN PARTICULAR FOR A DIGITAL/ANALOGUE CONVERTER IN CONTINUOUS TIME SIGMA/DELTA MODULATORS

SOURCE DE COURANT COMMANDEE CONCUE EN PARTICULIER POUR DES CONVERTISSEURS NUMERIQUE-ANALOGIQUE MIS EN OEUVRE DANS DES MODULATEURS SIGMA-DELTA CONSTANTS DANS LE TEMPS

(84) Benannte Vertragsstaaten:
**DE FR GB**

(30) Priorität: **09.10.2002 DE 10247133**

(43) Veröffentlichungstag der Anmeldung:
**06.07.2005 Patentblatt 2005/27**

(73) Patentinhaber: **Infineon Technologies AG**
**81669 München (DE)**

(72) Erfinder:
 • **ORTMANNS, Maurits**
 **79100 Freiburg (DE)**
 • **MANOLI, Yiannos**
 **79104 Freiburg (DE)**
 • **GERFERS, Friedel**
 **47199 Duisburg (DE)**

(74) Vertreter: **Reinhard - Skuhra - Weise & Partner**
**Postfach 44 01 51**
**80750 München (DE)**

(56) Entgegenhaltungen:
US-A- 4 509 037        US-A- 4 998 109
US-A- 5 227 795        US-A1- 2002 011 945

 • ZWAN VAN DER E J ET AL: "A 0.2-MW CMOS SIGMA DELTA MODULATOR FOR SPEECH CODING WITH 80 DB DYNAMIC RANGE" IEEE JOURNAL OF SOLID-STATE CIRCUITS, IEEE INC. NEW YORK, US, Bd. 31, Nr. 12, 1. Dezember 1996 (1996-12-01), Seiten 1873-1880, XP000691804 ISSN: 0018-9200
 • LERCH R G ET AL: "A MONOLITHIC SIGMA DELTA A/D AND D/A CONVERTER WITH FILTER FOR BROAD-BAND SPEECH CODING" IEEE JOURNAL OF SOLID-STATE CIRCUITS, IEEE INC. NEW YORK, US, Bd. 26, Nr. 12, 1. Dezember 1991 (1991-12-01), Seiten 1920-1926, XP000272852 ISSN: 0018-9200

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

## Beschreibung

## Technisches Anwendungsgebiet

Die vorliegende Erfindung betrifft eine gesteuerte Stromquelle, die in Abhängigkeit von einer an einem Steuereingang anliegenden Steuerspannung einen Ausgangsstrom erzeugt, mit einer Steuereinrichtung zur Umsetzung eines Taktsignales in ein Spannungssignal, wobei die Steuereinrichtung so mit der Stromquelle verbunden ist, dass das Spannungssignal als Steuerspannung am Steuereingang der Stromquelle anliegt. Die Erfindung betrifft weiterhin einen Digital-Analog-Umsetzer mit der gesteuerten Stromquelle, einen Sigma-Delta-Analog-Digital-Umsetzer mit zeitkontinuierlichem Sigma-Delta-Modulator mit dem Digital-Analog-Umsetzer sowie ein Verfahren zum Betrieb.

Sigma-Delta-Analog-Digital-Umsetzer und deren Hauptbestandteil, der Sigma-Delta-Modulator, konnten in den letzten Jahren unter Einsatz neuer Technologien hinsichtlich ihrer Auflösung und ihrer Umsetzraten deutlich verbessert werden. Dies ermöglicht den Einsatz von Sigma-Delta-Analog-Digital-Umsetzern in Anwendungen, die von hochauflösenden Audio-Umsetzern bis hin zu FrontEnd-Schaltungen von Mobilfunksystemen (GSM, UMTS) sowie Schnittstellen in Kommunikations- und Informationstechnologien (DSL, Cable) reichen. Für diese Anwendungen sind sehr hohe Umsetzraten erforderlich, die zusammen mit der in diesen Systemen eingesetzten Überabtastung sehr hohe Systemgeschwindigkeiten bzw. Abtastfrequenzen benötigen. Dies wiederum stellt sehr hohe Anforderungen an die einzelnen Komponenten des Sigma-Delta-Modulators.

## Stand der Technik

Üblicherweise wurden Sigma-Delta-Modulatoren bisher zeitdiskret in Schalter-Kondensator (SC) Technik realisiert. Diese Technik weist gute Eigenschaften bezüglich der Komponenten-Abstimmung, der Simulierbarkeit und anderer Merkmale auf. Gerade die hohen Geschwindigkeitsanforderungen neuer Anwendungen sind mit zeitdiskreten Sigma-Delta-Modulatoren jedoch nur schwer zu realisieren, da zum einen die Geschwindigkeitsanforderungen an die SC-Systemkomponenten um ein Vielfaches höher liegen als die Systemgeschwindigkeit selbst, desweiteren die Abtast-Halte-Glieder (S/H) bei hohen Geschwindigkeiten immer schwerer realisierbar sind und schließlich das Einhalten der Geschwindigkeitsanforderungen zu hohem Stromverbrauch führt, der in vielen Anwendungen, wie beispielsweise beim Einsatz in mobilen Systemen, möglichst vermieden werden soll.

Aus diesen und weiteren Gründen wurden in letzter Zeit so genannte zeitkontinuierliche Sigma-Delta-Modulatoren entwickelt, die aktive RC-Integratoren, GmC-Integratoren oder Ähnliches einsetzen. Die Systemkomponenten dieser Schaltungen sind bezüglich der Geschwindigkeitsanforderungen weniger kritisch, so dass sie sich für den Einsatz auf den neuen Anwendungsgebieten der Kommunikationselektronik anbieten. Andererseits sind die zeitkontinuierlichen Sigma-Delta-Modulatoren sehr viel empfindlicher gegenüber einigen Nichtidealitäten, die besonders in einem industriellen, alltäglichen Umfeld vorhanden sind. Eine wesentliche Rolle spielt hierbei das so genannte Clock-Jitter, d.h. statistische Schwankungen in der Frequenz des Systemtaktes. Diese Schwankungen sind bei zeitdiskreten Sigma-Delta-Modulatoren unkritisch, da dort alle Signale ihren Beharrungswert angenommen haben, bevor der Systemtakt das nächste Mal schaltet. In diesem Fall ist ein durch Clock-Jitter verfälschtes Abtasten des Eingangssignals (S/H) die Hauptfehlerquelle. Bei zeitkontinuierlichen Sigma-Delta-Modulatoren wird jedoch das Rückkopplungssignal des Digital-Analog-Umsetzers (DAU) durch diesen Systemtakt geschaltet. Ein statistisch variiertes Schalten aufgrund eines Clock-Jitter bewirkt in diesem Fall einen statistisch variierten Rückkopplungsfehler, der die Gesamtauflösung des Systems erheblich reduzieren kann. Das maximal tolerierbare Clock-Jitter ist in zeitkontinuierlichen Schaltungen je nach Auflösung, Realisierung usw. um mehr als zwei bis drei Dekaden kleiner als in einer vergleichbaren zeitdiskreten Schaltung.

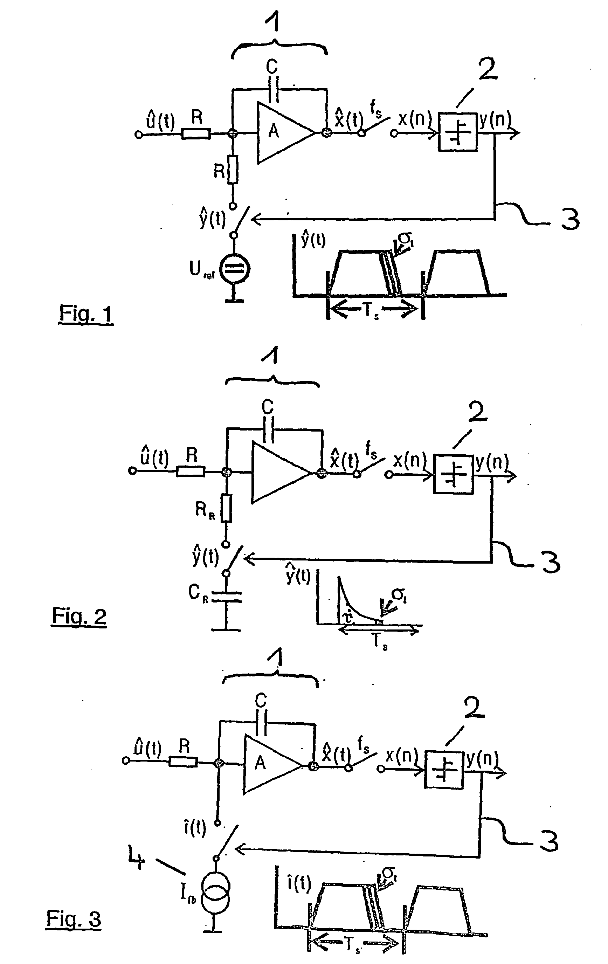

Fig. 1 zeigt ein Beispiel eines zeitkontinuierlichen Sigma-Delta-Modulators erster Ordnung. Der Sigma-Delta-Modulator wird durch einen analogen Integrator 1, bestehend aus einem Operationsverstärker A und einer Kapazität C, sowie einem nachgeschalteten Quantisierer 2 gebildet. Das vom Quantisierer 2 erzeugte digitale Signal $y(n)$ wird über einen Rückkopplungszweig 3 nach einer Digital-Analog-Umsetzung auf den Eingang des Integrators 1 gelegt, auf dem auch das Eingangssignal $ü(t)$ anliegt. Der Integrator 1 integriert das überlagerte Signal, wobei das Ausgangssignal $x^(t)$ des Integrators 1 mit einer vorgebbaren Taktfrequenz $f_s$ abgetastet und das abgetastete Signal $x(n)$ durch den Quantisierer 2 digitalisiert wird. Die Wirkungsweise eines derartigen Sigma-Delta-Modulators ist dem Fachmann bekannt. Im Beispiel der Fig. 1 wird der Digital-Analog-Umsetzer des Rückkopplungszweiges 3 durch eine Spannungsquelle $U_{ref}$ gebildet, deren Spannung zwischen zwei Referenzwerten in Abhängigkeit vom Taktsignal geschaltet wird. Bei einer Schwankung der Taktdauer durch ein Clock-Jitter wird jedoch ein unterschiedlich langer Spannungsimpuls erzeugt, wie dies anhand des Diagrammes der Fig. 1 zu erkennen ist, dass das erzeugte Spannungssignal $y^(t)$ in Abhängigkeit von der Zeit zeigt. $T_s$ gibt hierbei den Abstand zwischen zwei steigenden Flanken des Taktsignals, d. h. die Taktdauer an. Durch die vom Clock-Jitter verursachte unterschiedliche Länge der erzeugten Spannungsimpulse, über die im Integrator 1 integriert wird, wird die Gesamtauflösung des Systems erheblich reduziert, da sich das Clock-Jitter gerade durch die Integration sehr stark auswirkt.

Zur Verminderung dieser Problematik beim Einsatz zeitkontinuierlicher Sigma-Delta-Modulatoren wurde beispielsweise in M. Ortmanns et al., "Neue DAU-Rückkopplung für zeitkontinuierliche SD-Modulatoren, ITG-Tagung, VDI, 2000 oder in M. Ortmanns et al., "Jitter Insensitiv Feed-back DAC for Continuous-Time Sigma-Delta-Modulators", International Conference und Electronics, Circuits and Systems, ICECS 01, ein Digital-Analog-Umsetzer im Rückkopplungszweig vorgeschlagen, bei dem eine zusätzliche Kapazität eingesetzt wird. Eine derartige Ausgestaltung ist schematisch in der Fig. 2 angedeutet. Die Kapazität $C_R$ wird hierbei auf eine der beiden Rückkopplungsreferenzspannungen aufgeladen, und zwar abhängig vom aktuellen digitalen Rückkopplungswert. Diese Kapazität wird dann über einen zusätzlichen Widerstand $R_R$ auf den Integrator 1 des Sigma-Delta-Modulators entladen. Sofern die Entladezeit der Kapazität (C*R) genügend klein gegenüber der Taktdauer ist, ist das rückgekoppelte Signal unabhängig von der auftretenden Variation der Taktdauer. Dies ist im Diagramm der Fig. 2 veranschaulicht, in dem wiederum das Rückkopplungssignal y^(t) in Abhängigkeit von der Zeit aufgetragen ist, wobei die Taktdauer $T_S$ durch den Doppelpfeil angedeutet ist. Aus dieser Figur ist ersichtlich, dass das Rückkopplungssignal y^(t) von einem anfänglichen Maximalwert innerhalb der Taktdauer auf einen Minimalwert abfällt, wobei die Dauer des Abfalls sowie der Minimalwert derart gewählt sind, dass sich eine Variation in der Taktdauer nur minimal auf die anschließende Integration über dieses Rückkopplungssignal auswirkt. Das rückgekoppelte Signal ist somit weitgehend unabhängig von der auftretenden Variation der Taktdauer. Eine derartige Technik zur Reduzierung der Sensitivität eines zeitkontinuierlichen Sigma-Delta-Modulators auf ein Clock-Jitter ist auch in der WO 00/36750 beschrieben. In dieser Druckschrift wird der Digital-Analog-Umsetzer im Rückkopplungszweig durch eine Kapazität, einen Widerstand, zwei Schalter sowie einen Dipolschalter realisiert, der zwischen den beiden Referenzspannungen umschaltet.

Gegenüber zeitdiskreten Realisierungen des Sigma-Delta-Modulators hat diese Technik den Vorteil, dass die erforderliche Slew-Rate der benutzten Verstärker durch den eingeführten Widerstand $R_R$ deutlich reduziert ist. Auf der anderen Seite muss der eingesetzte Verstärker jedoch eine höhere Bandbreite als in üblichen zeitkontinuierlichen Modulatoren aufweisen, um den ihm durch die Entladung der Kapazität aufgeschalteten Strompuls sehr schnell auf die Integrationskapazität laden zu können. Wird die Bandbreite des Verstärkers nicht groß genug gewählt, so ergibt sich zum einen ein Fehler, der sich in der maximalen Auflösung des Modulators niederschlägt und zum anderen auch eine künstliche Verlangsamung der Kapazitätsentladung, die wiederum zu einer höheren Jitter-Empfindlichkeit führen kann.

Ein weiterer Nachteil der vorgenannten Technik besteht darin, dass eine möglichst variable Implementierung des vorgestellten Digital-Analog-Umsetzers für jeden Rückkopplungspfad einen Widerstand, über den entladen wird, sowie zwei Kapazitäten erfordert, die auf jeweils eine der beiden Referenzspannungen aufgeladen werden, und von denen, abhängig vom aktuellen digitalen Modulator-Ausgangs- bzw. Taktsignal, eine pro Takt über den Widerstand entladen wird. Damit erhöht sich die Anzahl der Bauelemente und somit die für die Herstellung benötigte Chipfläche, so dass zusätzliche Kosten entstehen.

Die hohen Signalspitzen, die am Anfang des Entladungsvorgangs auf den Integrator fließen, bewirken auch eine Variation in dessen Eingangsspannungsverhalten. Insbesondere die Eingangs-Common-Mode-Spannung wird sich schlagartig ändern, bevor sie durch das so genannte Common-Mode-Feed-back (CMFB) wieder auf ihren eigentlichen Wert ausgeregelt werden kann. Dauert dies länger als eine Taktlänge oder variiert die Common-Mode-Spannung aus anderen Gründen von einem zum nächsten Takt, beispielsweise durch Aussteuerung des Verstärkers, so variiert auch das Rückkopplungssignal, da der Strom i, der auf den Integrator fließt, folgender Gleichung folgt:

$$i = \frac{V_{\mathrm{Ref}} - V_{CM}}{R} \cdot e^{\frac{t}{R \cdot C}}$$

wobei $V_{\mathrm{Ref}}$ eine der Referenzspannungen, $V_{CM}$ die Verstärker Common-Mode-Spannung, R der Rückkopplungswiderstand sowie C die Rückkopplungskapazität darstellen. Es ist leicht erkennbar, dass eine Variation von $V_{CM}$ das Rückkopplungssignal verändert. Dies bedeutet aber, dass abhängig von der Länge des mit dem Clock-Jitter behafteten Taktes ein Fehler eingespeist wird, der eine Verminderung der Auflösung zur Folge hat.

Ein weiterer Nachteil der dargelegten Lösung ergibt sich bei so genannten Multibit-Realisierungen des Modulators. Dabei wird im internen Quantisierer mehr als ein Bit aufgelöst, wodurch zum einen die Stabilität und zum anderen die Auflösung des Modulators erhöht werden. Dies stellt jedoch hohe Anforderungen an die Linearität des Digital-Analog-Umsetzers im Rückkopplungszweig, der nun die Linearität des gesamten Systems aufweisen muss. Einige Realisierungen dieser Technik sehen hierbei ein geschicktes Lay-out durch Aufteilen der Rückkopplungselemente in Einheitselemente und eine statistische Verteilung dieser Elemente auf der vorhandenen Fläche vor, um möglichst äquidistante DAU-Schritte zu erhalten. Darüber hinaus sind Techniken bekannt, die Einheitsquellen quasi zufällig zum gewünschten Wert zusammenzuschalten, um somit den Fehler statistisch auszumitteln. Eine derartige Technik ist beispielsweise unter dem Begriff Dynamic Element Matching bekannt. Bei all diesen Techniken sieht man sich mit der bisherigen Lösung des Clock-Jitter unempfindlichen Digital-Analog-Umsetzers enormen Problemen gegenüber, da hier zwei Elemente, Widerstand und Kapazität, mit anderen Einheitselementen dieser Art in die vorhandenen Techniken eingebettet werden müssen. Die US-Patentschrift US-A-4 509 037 zeigt eine gesteuerte Stromquelle nach dem Oberbegriff des Anspruchs 1.

Ausgehend von diesem Stand der Technik besteht die Aufgabe der vorliegenden Erfindung darin, eine Vorrichtung anzugeben, die die Realisierung eines Digital-Analog-Umsetzers für einen zeitkontinuierlichen Sigma-Delta-Modulator ermöglicht, der eine geringere Empfindlichkeit des zeitkontinuierlichen Modulators gegenüber Clock-Jitter aufweist. Mit dem Digital-Analog-Umsetzer sollen auch die vorgenannten Nachteile vermieden werden.

**Darstellung der Erfindung**

Die Aufgabe wird mit der gesteuerten Stromquelle gemäß Patentanspruch 1 gelöst. Die Patentansprüche 5, 7 und 11 geben einen Digital-Analog-Umsetzer, einen Sigma-Delta-Analog-Digital-Umsetzer sowie ein Verfahren zum Betrieb an, bei denen die vorgeschlagene Stromquelle eingesetzt wird, um die Empfindlichkeit gegenüber Clock-Jitter zu vermindern.

Die vorliegende gesteuerte Stromquelle, insbesondere für Digital-Analog-Umsetzer in zeitkontinuierlichen Sigma-Delta-Modulatoren, mit einem Steuereingang, die in Abhängigkeit von einer am Steuereingang anliegenden Steuerspannung einen Ausgangsstrom erzeugt, weist eine Steuereinrichtung zur Umsetzung eines Taktsignals in ein Spannungssignal auf, wobei die Steuereinrichtung so mit der Stromquelle verbunden ist, dass das Spannungssignal als Steuerspannung am Steuereingang der Stromquelle anliegt. Die gesteuerte Stromquelle zeichnet sich dadurch aus, dass die Steuereinrichtung zur Umsetzung des Taktsignales in ein Spannungssignal ausgebildet ist, das jeweils innerhalb einer Taktdauer einen reproduzierbaren Verlauf aufweist, der mit einer abfallenden Flanke endet.

Bei dieser gesteuerten Stromquelle wird die Steuerspannung, die in der Regel die Gate-/Basisspannung der Stromquelle darstellt, nicht über den gesamten Taktzeitraum konstant gehalten, sondern reproduzierbar mit einer fallenden Signalflanke gespeist. Diese Signalflanke muss den Strom innerhalb eines Taktes auf genügend kleine Werte begrenzen, so dass eine verfrühte oder verspätete Abschaltung durch Clock-Jitter einen genügend kleinen Fehler in einer nachgeschalteten Anwendung verursacht, die eine Bereitstellung konstanter Strompakete unabhängig von Clock-Jitter erfordert.

In einer bevorzugten Ausgestaltung wird die gesteuerte Stromquelle zur Umsetzung eines digitalen Signales in ein Stromsignal in einen Digital-Analog-Umsetzer implementiert, im Folgenden auch als Stromquellen-DAU bezeichnet, wobei das digitale Signal mit der Stromquelle oder der Steuereinrichtung verbunden ist. Hierbei kann der durch Clock-Jitter im Integrator eines zeitkontinuierlichen Sigma-Delta-Modulators verursachte Fehler sehr klein gehalten werden und somit ohne Auswirkung bleiben.

Beim Einsatz eines derartigen Digital-Analog-Umsetzers im Rückkopplungszweig eines Sigma-Delta-Modulators wird somit das Rückkopplungssignal bzw. der Rückkopplungsstrom direkt durch das Ein- oder Ausschalten der Stromquelle erzeugt. Diese Methode ist sehr unempfindlich gegenüber Spannungsschwankungen am Integratoreingang, da der Sollstrom einer Stromquelle idealerweise unabhängig von der über ihr anliegenden Spannung geliefert wird. Desweiteren sind Stromquellen-DAUs sehr gut als Multibit-Digital-Analog-Umsetzer implementierbar, da Einheitsstromquellen, in der Regel Transistoren, verwendet werden. Alle bekannten Linearisierungstechniken lassen sich hierbei anwenden. Weiterhin führt die Verwendung von Stromquellen-DAUs zu einer Reduzierung der für die Herstellung erforderlichen Chipfläche, so dass Kosten in der Produktion eingespart werden. Durch die Erzeugung der Steuerspannung für die Stromquelle mittels eines Spannungspulses, der reproduzierbar innerhalb der Taktdauer von einem Maximalwert über eine fallende Flanke auf einen Minimalwert abfällt, weist auch der Ausgangsstrom der Stromquelle eine derartige abfallende Flanke auf. Damit wird erreicht, dass der Fehler, der bei falschem Schalten des Systemtaktes aufgrund eines Clock-Jitter verursacht wird, genügend klein ist. Sein Einfluss auf die Auflösung des Sigma-Delta-Modulators ist bei günstiger Einstellung der fallenden Flanke sowie des Minimalwertes vernachlässigbar, da sich die Schwankungen nur im Bereich des Minimalwertes auswirken und somit bei einer Integration keine großen Abweichungen verursachen.

Die vorgeschlagene Implementierung eines mit der erfindungsgemäß gesteuerten Stromquelle ausgestalteten Digital-Analog-Umsetzers in einen Sigma-Delta-Modulator ist sehr einfach, da übliche, vielleicht sogar schon implementierte Stromquellen-DAUs inklusive aller Linearisierungstechniken, Singlebit und Multibit, verwendet werden können. Für die Clock-Jitter unempfindliche Implementierung muss lediglich die abfallende Flanke reproduzierbar zur Verfügung gestellt werden und dies im Idealfall nur einmalig für den gesamten Modulator. Der eingespeiste Strompuls, der von der Stromquelle geliefert wird, ist weitgehend unabhängig von der Common-Mode-Eingangsspannung ($V_{CM}$) des Integrators. Daher wird die Rückkopplung in der realen Implementierung aufgrund von $V_{CM}$-Schwankungen nur wenig variieren, so dass sich wiederum eine verbesserte Jitter-Unempfindlichkeit ergibt.

Bei einer Implementierung des Sigma-Delta-Modulators mit Gm-C-Integratoren ist es auch möglich, die Stromquelle direkt auf die Integrationskapazitäten des Modulators bzw. Gm-C-Integrators zu führen, die dann den Strom zur Ausgangsspannung aufintegriert. Die Gm-Zelle, die das Eingangsspannungssignal in einen proportionalen Strom umsetzen soll, wird dabei vom hohen Rückkopplungsstrompuls nicht belastet, so dass sie nur mit einer üblich geringen Slew-Rate und geringen Bandbreite vorgesehen werden muss.

Als Stromquelle bzw. Stromquellen werden vorzugsweise Transistoren eingesetzt, die im Sättigungsbetrieb arbeiten. Bei einem MOS-Transistor wird dieser Sättigungsbetrieb durch eine Drain-Source-Spannung realisiert, die größer als die effektive Gate-Source-Spannung ist. Der Ausgangsstrom ist dabei weitgehend unabhängig von der Drain-Source-Spannung. Der Transistor liegt mit dem Emitter (Source) an konstantem Potential, mit dem Kollektor (Drain) am zu beliefernden Knoten, insbesondere den Integratoreingängen des Modulators, und mit der Basis (Gate) am Steuerpotential der Steuereinrichung. Das Potential an der Basis stellt zusammen mit dem W/L-Verhältnis des Transistors den Ausgangsstrom mit reproduzierbar abfallender Flanke der auf diese Weise realisierten Stromquelle ein. Im vorliegenden Fall wird dieses Potential jeweils innerhalb einer Taktdauer so verändert, dass es vom Maximal- auf den Minimalwert abfällt.

Darüber hinaus sind selbstverständlich auch andere Schaltungen einsetzbar, die beispielsweise mittels eines Kaskode-Transistors oder in Form einer Stromquellenrealisierung nach Wilson oder Widlar eine verbesserte Stromquelle mit höherem Innenwiderstand realisieren. Das wesentliche Merkmal des vorliegenden Digital-Analog-Umsetzers ist nicht die eigentliche Stromquelle, sondern die Steuereinrichtung, die die Stromquelle mit der abfallenden Steuerspannung ansteuert.

Diese Steuereinrichtung kann in unterschiedlicher Weise realisiert werden. So ist jede Einrichtung einsetzbar, die eine reproduzierbare Spannung liefert, die entweder zuerst ansteigt und dann wieder reproduzierbar auf den Ausgangswert abfällt, oder die bei einem Startwert beginnt und auf einen Endwert abfällt. Bedingung ist, dass die Werte in jeder Taktphase im Rahmen der Modulatorauflösung gleich sind und der Wert, der am Ende einer Taktphase als Steuerungssignal an der Stromquelle anliegt, einen genügend kleinen Strom verursacht, so dass ein falscher Schaltzeitpunkt des Taktes einen genügend kleinen Fehler verursacht.

Ein Beispiel für eine derartige Steuereinrichtung ist eine Schaltung aus einer Kapazität C und einem Widerstand R. Die Kapazität C wird vorher auf die Referenzspannung aufgeladen und über den Widerstand R nach Masse entladen. Die sich dabei einstellende Entladespannung wird als Steuersignal des Stromquellen-DAUs genutzt.

In einer weiteren Ausgestaltung der Steuereinrichtung wird ein so genannter Slope-Umsetzer genutzt, um eine fest definierte ansteigende und abfallende Flanke des Steuersignals der Stromquelle zu erhalten, die auch linear verlaufen kann. Ein derartiger Slope-Umsetzer kann beispielsweise ein RC-Integrator mit einer Spannungs- oder Stromquelle mit Ladekapazität sein. Hierbei erfolgt zunächst eine Integration des Taktsignals bis zu einem Referenzspannungswert auf einem Kondensator. Nach dem Schalten eines Komparators erfolgt eine Deintegration zur Erzeugung der abfallenden Flanke. Anschließend wird die Integrationskapazität auf Null entladen. Dieser Vorgang wird in der nächsten Taktphase wiederholt.

## Kurze Beschreibung der Zeichnungen

Die vorliegende Erfindung wird nachfolgend anhand von Ausführungsbeispielen in Verbindung mit den Zeichnungen nochmals kurz erläutert. Hierbei zeigen:

Fig. 1　　ein Beispiel für einen Sigma-Delta-Modulator gemäß dem Stand der Technik;

Fig. 2　　ein weiteres Beispiel für einen Sigma-Delta-Modulator des Standes der Technik, der eine reduzierte Empfindlichkeit gegenüber Clock-Jitter aufweist;

Fig. 3　　ein Beispiel für die Realisierung eines Sigma-Delta-Modulators mit einem herkömmlichen Stromquellen-DAU nach dem Stand der Technik;

Fig. 4　　ein Beispiel für die Ausgestaltung eines Sigma-Delta-Modulators mit einem Digital-Analog-Umsetzer und einer gesteuerten Stromquelle gemäß der vorliegenden Erfindung;

Fig. 5　　ein weiteres Beispiel für eine Ausgestaltung eines Sigma-Delta-Modulators mit einem Digital-Analog-Umsetzer und einer gesteuerten Stromquelle gemäß der vorliegenden Erfindung;

Fig. 6　　zwei Beispiele für die Ausgestaltung der Stromquelle des vorliegenden Digital-Analog-Umsetzers; und

Fig. 7　　drei Beispiele für die Ausgestaltung der Steuereinrichtung zur Erzeugung der Steuerspannung beim vorliegenden Digital-Analog-Umsetzer.

## Wege zur Ausführung der Erfindung

Die Ausgestaltungen der bekannten Sigma-Delta-Modulatoren des Standes der Technik gemäß den Fig. 1 und 2 wurden bereits in der Beschreibungseinleitung eingehend erläutert. Fig. 3 zeigt die Ausgestaltung eines Sigma-Delta-Modulators, bei dem der Digital-Analog-Umsetzer im Rückkopplungszweig 3 eine Stromquelle 4 aufweist. Auch bei diesem Sigma-Delta-Modulator wird das Eingangssignal ü(t) über einen Widerstand R am Eingang des Integrators 1 des Modulators mit dem Rückkopplungssignal überlagert. Der Integrator 1 besteht auch hier aus einem Operationsverstärker A und einer Kapazität C. Das integrierte Ausgangssignal x^(t) wird mittels einer Taktfrequenz $f_S$ abgetastet und das Abtastsignal x(n) einem Quantisierer 2 zugeführt, der ein digitales Ausgangssignal y(n) liefert. Dieses digitale Ausgangssignal wird über den Digital-Analog-Umsetzer auf den Eingang des Modulators rückgekoppelt. Hierbei wird die Stromquelle 4 in Abhängigkeit von dem als Taktsignal wirkenden digitalen Signal y(n) ein- und ausgeschaltet.

Im unteren Teil dieser Figur ist das getaktete Ausgangssignal î(t) der Stromquelle in Abhängigkeit von der Zeit aufgetragen. Wie deutlich ersichtlich ist, wirkt sich eine Schwankung in der Zeitdauer des Taktsignales auf die Länge der erzeugten Strompulse aus, die zu erheblichen Fehlern bei der anschließenden Integration im Modulator führen kann.

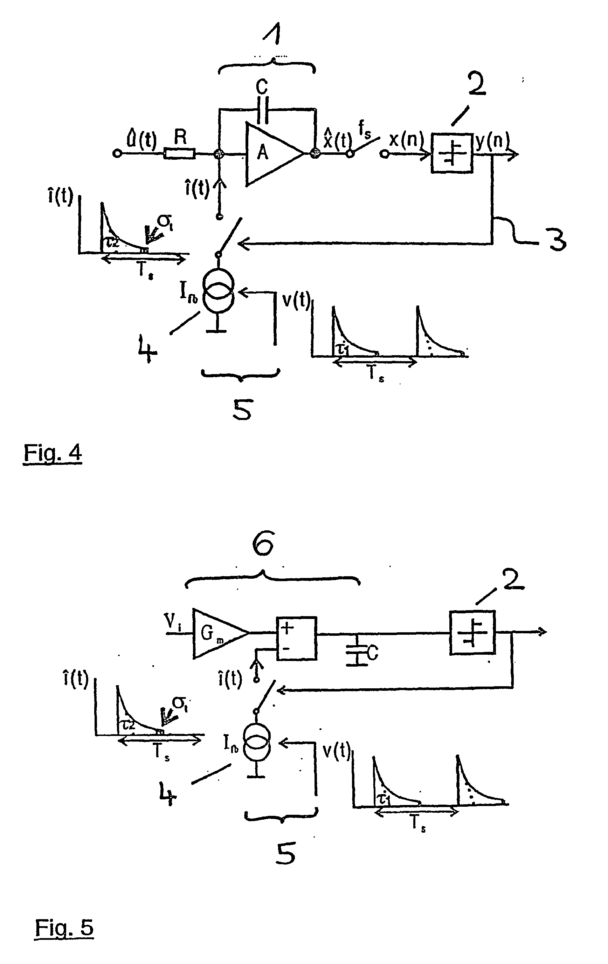

Bei Einsatz eines Digital-Analog-Umsetzers mit einer gesteuerten Stromquelle gemäß der vorliegenden Erfindung wird diese Empfindlichkeit gegenüber Clock-Jitter deutlich verringert. Ein Beispiel für die erfindungsgemäße Ausgestaltung des vorliegenden Digital-Analog-Umsetzers wird durch die Fig. 4 veranschaulicht, in der der Integrator 1 und Quantisierer 2 des Sigma-Delta-Modulators in gleicher Weise wie bei der Ausgestaltung der Fig. 3 realisiert sind. Lediglich im Rückkopplungszweig 3 wird diesmal ein Digital-Analog-Umsetzer 5 eingesetzt, der gemäß der vorliegenden Erfindung ausgestaltet ist. Auch dieser Digital-Analog-Umsetzer 5 weist wiederum eine Stromquelle 4 auf, die im vorliegenden Fall jedoch mit einer Steuerspannung v(t) angesteuert wird, die einen bestimmten vordefinierten Verlauf aufweist. Die Steuerspannung v(t), die durch eine spezielle, in dieser Figur nicht dargestellte Einrichtung des vorliegenden Digital-Analog-Umsetzers 5 erzeugt wird, ist im unteren rechten Teil der Figur schematisch angedeutet. Diese Steuerspannung v(t) steigt in diesem Beispiel am Anfang einer Taktdauer $T_S$ sehr schnell auf einen Maximalwert an und fällt dann mit einer definierten fallenden Flanke auf einen Minimalwert ab. Durch Ansteuerung der Stromquelle 4 mit einer dieser Steuerspannung v(t) ergibt sich ein Stromimpuls î(t), wie er im linken Bereich der Figur im Diagramm angedeutet ist. Dieser Strompuls weist im Wesentlichen den zeitlichen Verlauf der Steuerspannung v(t) auf. Aufgrund dieses Verlaufs des Stromimpulses wirkt sich eine Schwankung in der Taktdauer nur in einem Bereich des Stromimpulses aus, in dem der Strom bereits einen sehr niedrigen Wert erreicht hat. Bei einer Integration über die Strompulse, wie sie im Modulator durchgeführt wird, wirkt sich somit die Schwankung in der Taktdauer nicht oder nur sehr unwesentlich auf das Ergebnis aus, so dass ein zeitkontinuierlicher Sigma-Delta-Modulator zur Verfügung steht, der unempfindlich gegenüber Clock-Jitter ist.

Fig. 5 zeigt eine weitere Möglichkeit des Einsatzes des vorliegenden Digital-Analog-Umsetzers mit der gesteuerten Stromquelle in einem zeitkontinuierlichen Sigma-Delta-Modulator. In diesem Fall ist der Integrator des Sigma-Delta-Modulators durch einen Gm-C-Integrator 6 gebildet, der sich im Wesentlichen aus einer Gm-Zelle und einem gegen Masse geschalteten Kondensator zusammensetzt. Bei einer derartigen Ausgestaltung des Integrators des Sigma-Delta-Modulators kann das Ausgangssignal, d.h. der Ausgangsstrompuls, des erfindungsgemäßen Digital-Analog-Umsetzers direkt auf den Kondensator C gelegt werden, über den dann der Strom zur Ausgangsspannung aufintegriert wird. Diese Ausgestaltung hat den Vorteil, dass die Gm-Zelle nicht an den Rückkopplungsstrompuls angepasst werden muss, d.h. keine erhöhte Bandbreite aufweisen muss.

Aus einem Sigma-Delta-Modulator, wie er beispielsweise in den Figuren 1 bis 5 dargestellt ist, wird in bekannter Weise in Verbindung mit einem nachgeschalteten Dezimationsfilter ein Sigma-Delta-Analog-Digital-Umsetzer erhalten.

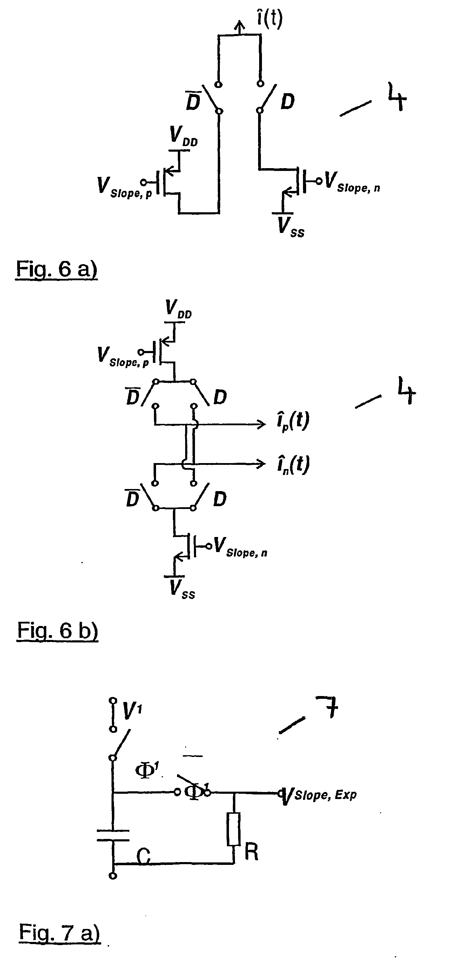

Fig. 6 zeigt zwei Beispiele für die mögliche Ausgestaltung der Stromquelle 4 des vorliegenden Digital-Analog-Umsetzers 5.

In Fig. 6 a) ist hierbei eine beispielhafte Implementierung mit MOS-Transistoren gezeigt. D ist der digitale Modulator-Ausgang und î der Rückkopplungsstrom der beiden vorangehenden Figuren. $V_{Slope,p}$ und $V_{Slope,n}$ stellen die gemäß der vorliegenden Erfindung ausgebildeten Spannungsflanken der Steuerspannung v(t) dar, die den jeweiligen Transistorstrom steuern. Diese müssen so gewählt sein, dass der Rückkopplungsstrom zum Abschaltzeitpunkt des Taktes hinreichend verkleinert ist, so dass Takt-Jitter keinen Einfluss hat. Vss und Vdd sind die Betriebsspannungen der Transistoren oder andere Referenzspannungen.

Fig. 6 b) zeigt eine beispielhafte Implementierung der Stromquelle 4 des Digital-Analog-Umsetzers 5 mit MOS-Transistoren für Fully-Differential-Architektur. Werden so genannte voll-differentielle Verstärker/Integratoren/Gm-Zellen verwendet, bei denen sowohl positiver als auch negativer Ein- und Ausgang für die Signalführung benutzt werden, so kann der Digital-Analog-Umsetzer 5 beispielsweise durch passendes Schalten der Stromquellen in der gezeigten Schaltung implementiert werden. Dabei sind $î_n(t)$ und $î_p(t)$ die Rückkopplungsströme auf den entsprechenden Eingang des Modulators. Die anderen Bezeichnungen wurden bereits bei der Beschreibung der Teilabbildung a) erläutert.

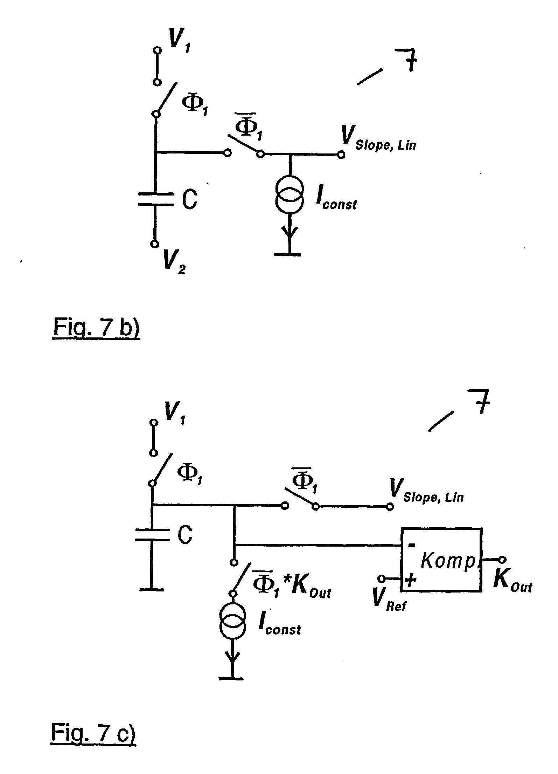

In Figur 7 sind drei Beispiele für die mögliche Ausgestaltung der Steuereinrichtung 7 zur Erzeugung der Steuerspannung beim vorliegenden Digital-Analog-Umsetzer 5 bzw. der gesteuerten Stromquelle dargestellt.

Fig. 7 a) zeigt eine beispielhafte Implementierung der Steuereinrichtung 7 zur Erzeugung einer exponentiellen Ansteuerspannung $V_{Slope,Exp}(t)$ für die Transistor-Stromquellen 4 mittels einer RC-Schaltung. $V_1$ und $V_2$ sind die Anfangs- und Endspannung des Entladevorgangs. $\Phi_1$ ist ein Taktsignal, so dass während einer ersten Taktphase die Kapazität C geladen und während der zweiten Taktphase über den Widerstand R entladen wird. Dieser Takt kann der Systemtakt sein. Die Spannungen $V_1$ und $V_2$ müssen für p- und n-Kanal Transistoren unterschiedlich gewählt sein (n: $V_1 > V_2$, p: $V_1 < V_2$).

Der zeitliche Ausgangsspannungsverlauf ist bei dieser Ausgestaltung exponentiell.

Fig. 7 b) zeigt eine beispielhafte Implementierung der Steuereinrichtung 7 zur Erzeugung einer linearen Ansteuerspannung $V_{Slope,Lin}(t)$ für die Transistor-Stromquellen 4. $V_1$ und $V_2$ sind wiederum die Anfangs- und Endspannung des Entladevorgangs. $\Phi_1$ ist ein Taktsignal, so dass während einer ersten Taktphase die Kapazität C geladen und während der zweiten Taktphase durch die Konstantstromquelle $I_{const}$ entladen wird. Dieser Takt kann der Systemtakt sein. Die Spannungen $V_1$ und $V_2$ sowie der Strom $I_{const}$ müssen für p- und n-Kanal Transistoren unterschiedlich gewählt sein. Der zeitliche Ausgangsspannungsverlauf ist bei dieser Ausgestaltung linear.

Fig. 7 c) zeigt eine weitere beispielhafte Implementierung der Steuereinrichtung 7 zur Erzeugung einer linearen Ansteuerspannung $V_{Slope,Lin}(t)$ für die Transistor-Stromquellen 7, in diesem Beispiel mit einem Slope-Umsetzer. $V_1$ ist die Anfangsspannung des Entladevorgangs. $\Phi_1$ ist ein Taktsignal, so dass während einer Taktphase die Kapazität C geladen und während der zweiten Taktphase durch die Konstantstromquelle $I_{const}$ entladen wird. Dieser Takt kann der Systemtakt sein. Der Entladevorgang wird gestoppt, sobald die Spannung über der Kapazität C einen gewissen Wert $V_{Ref}$ über- oder unterschreitet. Die Spannungen $V_1$ und $V_{Ref}$ sowie der Strom $I_{const}$ müssen für p- und n-Kanal Transistoren unterschiedlich gewählt sein. Der zeitliche Ausgangsspannungsverlauf ist auch in dieser Ausgestaltung linear.

Selbstverständlich lassen sich neben diesen Realisierungen auch andere dem Fachmann bekannte Stromquellen sowie andere Einrichtungen einsetzen, die einen entsprechenden zeitlichen Verlauf der Steuerspannung v(t) in Abhängigkeit von einem Taktsignal liefern.

BEZUGSZEICHENLISTE

| 1 | Integrator |
| 2 | Quantisierer |
| 3 | Rückkopplungszweig |
| 4 | Stromquelle |
| 5 | Digital-Analog-Umsetzer |
| 6 | Gm-C-Integrator |
| 7 | Steuereinrichtung |

**Patentansprüche**

1. Gesteuerte Stromquelle, insbesondere für einen Digital-Analog-Umsetzer in einem zeitkontinuierlichen Sigma-Delta-Modulator, die eine Stromquelle (4) mit einem Steuereingang und eine Steuereinrichtung (7) zur Umsetzung eines Taktsignals in ein Spannungssignal aufweist, wobei die Stromquelle (4) in Abhängigkeit von einer am Steuereingang anliegenden Steuerspannung einen Ausgangsstrom erzeugt und die Steuereinrichtung (7) so mit der Stromquelle (4) verbunden ist, dass das Spannungssignal als Steuerspannung am Steuereingang der Stromquelle (4) anliegt,
**dadurch gekennzeichnet,**
**dass** die Steuereinrichtung (7) zur Umsetzung des Taktsignals in ein solches Spannungssignal ausgebildet ist, das innerhalb einer jeden Taktdauer einen reproduzierbaren Verlauf aufweist, der mit einer abfallenden Flanke endet.

2. Gesteuerte Stromquelle nach Anspruch 1,
**dadurch gekennzeichnet,**
**dass** die Steuereinrichtung (7) eine Kapazität und einen Widerstand umfasst, die derart verschaltet sind, dass die Kapazität über den Widerstand nach Masse entladen wird, wobei die Spannung über dem Widerstand dem Spannungssignal entspricht.

3. Gesteuerte Stromquelle nach Anspruch 1,
**dadurch gekennzeichnet,**
**dass** die Steuereinrichtung (7) einen Slope-Umsetzer umfasst.

4. Gesteuerte Stromquelle nach einem der Ansprüche 1 bis 3,
**dadurch gekennzeichnet,**
**dass** die Stromquelle (4) zumindest einen Transistor aufweist, dessen Gate den Steuereingang bildet.

5. Digital-Analog-Umsetzer, insbesondere für einen zeitkontinuierlichen Sigma-Delta-Modulator, mit einer gesteuerten Stromquelle nach einem der Ansprüche 1 bis 4.

6. Digital-Analog-Umsetzer nach Anspruch 5,
**dadurch gekennzeichnet,**
**dass** die gesteuerte Stromquelle zur Umsetzung eines digitalen Signales in ein Stromsignal ausgebildet ist, wobei das digitale Signal mit der Stromquelle (4) oder der Steuereinrichtung (7) verbunden ist.

7. Sigma-Delta-Analog-Digital-Umsetzer mit einem Sigma-Delta-Modulator, der über einen Rückkopplungszweig (3) ein Rückkopplungssignal erhält,
**dadurch gekennzeichnet,**
**dass** im Rückkopplungszweig (3) ein Digital-Analog-Umsetzer (5) nach Anspruch 5 angeordnet ist, dessen Ausgangsstrom des Rückkopplungssignal bildet.

8. Sigma-Delta-Analog-Digital-Umsetzer nach Anspruch 7,
**dadurch gekennzeichnet,**
**dass** der Sigma-Delta-Modulator ein zeitkontinuierlicher Sigma-Delta-Modulator ist

9. Sigma-Delta-Analog-Digital-Umsetzer nach Anspruch 7 oder 8,
**dadurch gekennzeichnet,**
**dass** der Digital-Analog-Umsetzer (5) derart mit dem Sigma-Delta-Modulator verbunden ist, dass das Rückkopplungssignal an einem oder mehreren Integratoren (1) des Sigma-Delta-Modulators anliegt.

10. Sigma-Delta-Analog-Digital-Umsetzer nach Anspruch 7 oder 8,
**dadurch gekennzeichnet,**
**dass** der Sigma-Delta-Modulator einen Gm-C-Integrator (6) aufweist und der Digital-Analog-Umsetzer (5) derart mit dem Sigma-Delta-Modulator verbunden ist, dass das Rückkopplungssignal direkt an einer Kapazität des Gm-C-Integrators (6) anliegt.

11. Verfahren zum Betrieb eines Sigma-Delta-Analog-Digital-Umsetzers mit zeitkontinuierlichem Sigma-Delta-Modulator, bei dem ein Rückkopplungssignal für den Sigma-Delta-Modulator durch Ein- und Ausschalten einer Stromquelle (4) in Abhängigkeit von einem Taktsignal des Sigma-Delta-Modulators erzeugt wird, die in Abhängigkeit von einer Steuerspannung einen Ausgangsstrom liefert,
**dadurch gekennzeichnet,**
**dass** die Steuerspannung der Stromquelle (4) so gewählt wird, dass sie jeden innerhalb einer Taktdauer einen reproduzierbaren Verlauf aufweist, der mit einer abfallenden Flanke endet.

12. Verfahren nach Anspruch 11,
**dadurch gekennzeichnet,**
**dass** der Ausgangsstrom direkt auf einen Eingang eines Integrators (1) des Sigma-Delta-Modulators gelegt wird.

13. Verfahren nach Anspruch 11,
**dadurch gekennzeichnet,**
**dass** der Ausgangsstrom bei Einsatz eines Gm-C-Integrators (6) im Sigma-Delta-Modulator direkt auf einen Kondensator des Gm-C-Integrators (6) gelegt wird.

14. Verfahren nach einem der Ansprüche 11 bis 13,
**dadurch gekennzeichnet**,
als Stromquelle (4) eine Transistorschaltung eingesetzt wird.

15. Verfahren nach einem der Ansprüche 11 bis 13,
**dadurch gekennzeichnet,**
**dass** die Steuerspannung der Stromquelle (4) über ein RC-Glied erzeugt wird.

16. Verfahren nach einem der Ansprüche 11 bis 13,
**dadurch gekennzeichnet,**
**dass** die Steuerspannung der Stromquelle (4) über einen Slope-Umsetzer erzeugt wird.

**Claims**

1. Controlled current source, in particular for a digital/analogue converter in a continuous-time sigma-delta modulator, which has a current source (4) having a control input and a control device (7) for converting a clock signal into a voltage signal, the current source (4) generating an output current on the basis of a control voltage which is applied to the control input and the control device (7) being connected to the current source (4) in such a manner that the voltage signal is applied as a control voltage to the control input of the current source (4),
**characterized in that**
the control device (7) is designed to convert the clock signal into such a voltage signal which, within each clock duration, has a reproducible profile which ends with a falling edge.

2. Controlled current source according to Claim 1,
**characterized in that**
the control device (7) comprises a capacitor and a resistor which are connected in such a manner that the capacitor is discharged to earth via the resistor, the voltage across the resistor corresponding to the voltage signal.

3. Controlled current source according to Claim 1,
**characterized in that**
the control device (7) comprises a slope converter.

4. Controlled current source according to one of Claims 1 to 3,
**characterized in that**
the current source (4) has at least one transistor whose gate forms the control input.

5. Digital/analogue converter, in particular for a continuous-time sigma-delta modulator, having a controlled current source according to one of Claims 1 to 4.

6. Digital/analogue converter according to Claim 5,
**characterized in that**
the controlled current source is designed to convert a digital signal into a current signal, the digital signal being connected to the current source (4) or to the control device (7).

7. Sigma-delta analogue/digital converter having a sigma-delta modulator which receives a feedback signal via a feedback path (3),
**characterized in that**

a digital/analogue converter (5) according to Claim 5 is arranged in the feedback path (3), the output current of said digital/analogue converter forming the feedback signal.

**8.** Sigma-delta analogue/digital converter according to Claim 7,
**characterized in that**
the sigma-delta modulator is a continuous-time sigma-delta modulator.

**9.** Sigma-delta analogue/digital converter according to Claim 7 or 8,
**characterized in that**
the digital/analogue converter (5) is connected to the sigma-delta modulator in such a manner that the feedback signal is applied to one or more integrators (1) of the sigma-delta modulator.

**10.** Sigma-delta analogue/digital converter according to Claim 7 or 8,
**characterized in that**
the sigma-delta modulator has a Gm-C integrator (6) and the digital/analogue converter (5) is connected to the sigma-delta modulator in such a manner that the feedback signal is directly applied to a capacitor of the Gm-C integrator (6).

**11.** Method for operating a sigma-delta analogue/digital converter having a continuous-time sigma-delta modulator, in which a feedback signal for the sigma-delta modulator is generated by switching a current source (4) on and off on the basis of a clock signal of the sigma-delta modulator, said current source providing an output current on the basis of a control voltage,
**characterized in that**
the control voltage of the current source (4) is selected in such a manner that, within each clock duration, it has a reproducible profile which ends with a falling edge.

**12.** Method according to Claim 11,
**characterized in that**
the output current is directly applied to an input of an integrator (1) of the sigma-delta modulator.

**13.** Method according to Claim 11,
**characterized in that**,
when using a Gm-C integrator (6) in the sigma-delta modulator, the output current is directly applied to a capacitor of the Gm-C integrator (6).

**14.** Method according to one of Claims 11 to 13,
**characterized in that**
a transistor circuit is used as the current source (4).

**15.** Method according to one of Claims 11 to 13,

**characterized in that**
the control voltage of the current source (4) is generated using an RC element.

**16.** Method according to one of Claims 11 to 13,
**characterized in that**
the control voltage of the current source (4) is generated using a slope converter.

**Revendications**

**1.** Source de courant commandée, notamment pour un convertisseur numérique - analogique dans un modulateur sigma - delta continu dans le temps, laquelle comporte une source de courant (4) avec une entrée de commande et un dispositif de commande (7) pour la conversion d'un signal d'horloge en un signal de tension, la source de courant (4) produisant un courant de sortie en fonction d'une tension de commande appliquée à l'entrée de commande et le dispositif de commande (7) étant relié de telle sorte à la source de courant (4) que le signal de tension se trouve comme tension de commande à l'entrée de commande de la source de courant (4),
**caractérisée par le fait que** le dispositif de commande (7) est conçu pour la conversion du signal d'horloge en un signal de tension tel qu'il comporte à l'intérieur de chaque période une allure reproductible qui se termine par un front descendant.

**2.** Source de courant commandée selon la revendication 1, **caractérisée par le fait que** le dispositif de commande (7) comprend une capacité et une résistance qui sont branchées de telle sorte que la capacité est déchargée par l'intermédiaire de la résistance vers la masse, la tension à la résistance correspondant au signal de tension.

**3.** Source de courant commandée selon la revendication 1, **caractérisée par le fait que** le dispositif de commande (7) comprend un convertisseur de pente.

**4.** Source de courant commandée selon l'une des revendications 1 à 3,
**caractérisée par le fait que** la source de courant (4) comporte au moins un transistor dont la grille forme l'entrée de commande.

**5.** Convertisseur numérique - analogique, notamment pour un modulateur sigma - delta continu dans le temps, avec une source de courant commandée selon l'une des revendications 1 à 4.

**6.** Convertisseur numérique - analogique selon la revendication 5,
**caractérisé par le fait que** la source de courant commandée est conçue pour la conversion d'un signal numérique en un signal de courant, le signal numérique étant relié à la source de courant (4) ou au dispositif de commande (7).

7. Convertisseur analogique - numérique sigma - delta avec un modulateur sigma - delta, qui reçoit un signal de rétroaction par l'intermédiaire d'une branche de rétroaction (3),
**caractérisé par le fait qu'**il y a dans la branche de rétroaction (3) un convertisseur numérique - analogique (5) selon la revendication 5 dont le courant de sortie forme le signal de rétroaction.

8. Convertisseur analogique - numérique sigma - delta selon la revendication 7,
**caractérisé par le fait que** le modulateur sigma - delta est un modulateur sigma - delta continu dans le temps.

9. Convertisseur analogique - numérique sigma - delta selon la revendication 7 ou 8,
**caractérisé par le fait que** le convertisseur numérique - analogique (5) est relié de telle sorte au modulateur sigma - delta que le signal de rétroaction est appliqué à un ou plusieurs intégrateurs (1) du modulateur sigma - delta.

10. Convertisseur analogique - numérique sigma - delta selon la revendication 7 ou 8,
**caractérisé par le fait que** le modulateur sigma - delta comporte un intégrateur Gm-C (6) et que le convertisseur numérique - analogique (5) est relié de telle sorte au modulateur sigma - delta que le signal de rétroaction est appliqué directement à une capacité de l'intégrateur Gm-C (6).

11. Procédé pour faire fonctionner un convertisseur analogique - numérique sigma - delta avec modulateur sigma - delta continu dans le temps, dans lequel on produit un signal de rétroaction pour le modulateur sigma - delta en mettant en circuit et hors circuit une source de courant (4) en fonction d'un signal d'horloge du modulateur sigma - delta, laquelle source de courant fournit un courant de sortie en fonction d'une tension de commande,
**caractérisé par le fait que** l'on choisit la tension de commande de la source de courant (4) de telle sorte qu'elle présente à l'intérieur de chaque période une allure reproductible qui se termine par un front descendant.

12. Procédé selon la revendication 11,
**caractérisé par le fait que** le courant de sortie est appliqué directement à une entrée d'un intégrateur (1) du modulateur sigma - delta.

13. Procédé selon la revendication 11,
**caractérisé par le fait que** le courant de sortie lors de l'utilisation d'un intégrateur Gm-C (6) dans le modulateur sigma - delta est appliqué directement à un condensateur de l'intégrateur Gm-C (6).

14. Procédé selon l'une des revendications 11 à 13,
**caractérisé par le fait que** l'on utilise comme source de courant (4) un circuit à transistors.

15. Procédé selon l'une des revendications 11 à 13,
**caractérisé par le fait que** l'on produit la tension de commande de la source de courant (4) par l'intermédiaire d'un élément RC.

16. Procédé selon l'une des revendications 11 à 13,
**caractérisé par le fait que** l'on produit la tension de commande de la source de courant (4) par l'intermédiaire d'un convertisseur de pente.

Fig. 1

Fig. 2

Fig. 3

**Fig. 4**

**Fig. 5**

**Fig. 6 a)**

**Fig. 6 b)**

**Fig. 7 a)**

$V_1$

$\Phi_1$

$\overline{\Phi}_1$

$V_{Slope, Lin}$

$C$

$I_{const}$

$V_2$

Fig. 7 b)

$V_1$

$\Phi_1$

$\overline{\Phi}_1$

$V_{Slope, Lin}$

$C$

$-$

$Komp.$

$K_{out}$

$+$

$V_{Ref}$

$\overline{\Phi}_1 * K_{Out}$

$I_{const}$

Fig. 7 c)

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 0036750 A
- US 4509037 A